# EUROPEAN PATENT APPLICATION

(11) **EP 2 736 067 A1**
(43) Date of publication of application: **28.05.2014**
(21) Application number: 12814532.3
(22) Date of filing: 25.05.2012
(51) Int. Cl.: H01L 21/265, H01L 21/336, H01L 29/12, H01L 29/78

(54) **METHOD FOR MANUFACTURING SEMICONDUCTOR DEVICE**

(30) Priority: 20.07.2011 JP 2011158784
(71) Applicant: Sumitomo Electric Industries, Ltd., Chuo-ku Osaka-shi Osaka 541-0041 (JP); National University Corporation Nara Institute of Science and Technology, Ikoma-shi, Nara 630-0192 (JP)
(72) Inventor: MASUDA, Takeyoshi, Osaka-shi, Osaka 554-0024 (JP); HATAYAMA, Tomoaki, Ikoma-shi, Nara 630-0192 (JP)
(74) Representative: Grünecker, Kinkeldey, Stockmair & Schwanhäusser
(86) International application number: PCT/JP2012/063476
(87) International publication number: WO 2013/011740

(57) **Abstract**

A method for manufacturing a MOSFET (1) includes the steps of: introducing an impurity into a silicon carbide layer (10); forming a carbon layer (81) in a surface layer portion of the silicon carbide layer (10) having the impurity introduced therein, by selectively removing silicon from the surface layer portion; and activating the impurity by heating the silicon carbide layer (10) having the carbon layer (81) formed therein.

## Description

### TECHNICAL FIELD

The present invention relates to a method for manufacturing a semiconductor device, and more particularly to a method for manufacturing a semiconductor device capable of performing activation annealing while protecting a surface more reliably.

### BACKGROUND ART

In recent years, in order to achieve high breakdown voltage, low loss, and utilization of semiconductor devices under a high temperature environment, silicon carbide has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

In a process for manufacturing such a semiconductor device using silicon carbide as its material, there may be adopted a step of introducing an impurity into a silicon carbide layer by ion implantation or the like and thereafter performing activation annealing to form a region having a conductivity type different from that of a surrounding region. The activation annealing is performed at a high temperature such as higher than 1500°C. Thus, from the viewpoint of suppressing surface roughening and the like, processes for performing annealing with a protective film deposited on a surface have been proposed (see, for example, Japanese Patent Laying-Open No. 2001-68428 (Patent Literature 1) and Japanese Patent Laying-Open No. 2005-353771 (Patent Literature 2)).

### CITATION LIST

### PATENT LITERATURE

PTL 1: Japanese Patent Laying-Open No. 2001-68428
PTL 2: Japanese Patent Laying-Open No. 2005-353771

### SUMMARY OF INVENTION

### TECHNICAL PROBLEM

However, when a protective film made of a material different from silicon carbide is arranged on a silicon carbide layer, a defect such as a crack may occur in the protective film as temperature is increased in activation annealing, due to a difference in linear expansion coefficient between the silicon carbide layer and the protective film, and the like. As a result, there may arise a problem that a surface of the silicon carbide layer is not sufficiently protected.

The present invention has been made to deal with such a problem, and one object of the present invention is to provide a method for manufacturing a semiconductor device capable of performing activation annealing while protecting a surface more reliably.

### SOLUTION TO PROBLEM

A method for manufacturing a semiconductor device in accordance with the present invention includes the steps of: introducing an impurity into a silicon carbide layer; forming a carbon layer in a surface layer portion of the silicon carbide layer having the impurity introduced therein, by selectively removing silicon from the surface layer portion; and activating the impurity by heating the silicon carbide layer having the carbon layer formed therein.

In the method for manufacturing a semiconductor device in accordance with the present invention, a carbon layer serving as a protective film is formed in a surface layer portion of the silicon carbide layer by selectively removing silicon from the surface layer portion. That is, by removing silicon from the surface layer portion of the silicon carbide layer, the surface layer portion is transformed into a carbon layer serving as a protective film. Thus, a defect such as a crack in the protective film due to a difference in linear expansion coefficient between the silicon carbide layer and the protective film and the like is suppressed, when compared with a conventional process of newly forming a protective film on a silicon carbide layer. As a result, the method for manufacturing a semiconductor device in accordance with the present invention can perform activation annealing while protecting a surface more reliably.

Here, a state where silicon is selectively removed from the surface layer portion of the silicon carbide layer refers to a state where, of the atoms constituting silicon carbide, silicon atoms are separated more than carbon atoms. Preferably, in the present invention, silicon atoms are separated at a rate ten times or more that of carbon atoms.

In the method for manufacturing a semiconductor device, in the step of forming the carbon layer, the silicon may be selectively removed by reaction of a halogen element and the silicon. Thereby, the silicon can be separated efficiently.

In the method for manufacturing a semiconductor device, in the step of forming the carbon layer, the silicon may be selectively removed by heating the silicon carbide layer in an atmosphere including a gas containing the halogen element. Further, in the method for manufacturing a semiconductor device, in the step of forming the carbon layer, the silicon may be selectively removed by holding the silicon carbide layer in a plasma containing the halogen element.

With such a method, formation of a carbon film by removal of the silicon using the halogen element can be accomplished relatively easily. Here, as the gas containing the halogen element, for example, chlorine (Cl₂) gas, fluorine (F₂) gas, bromine (Br₂) gas, iodine (I₂) gas, hydrogen chloride (HCl) gas, boron trichloride (BCl₃) gas, sulfur hexafluoride (SF₆) gas, carbon tetrafluoride (CF₄) gas, or the like can be adopted. Further, as the plasma containing the halogen element, for example, a plasma containing one or more elements selected from the group consisting of chlorine (Cl), fluorine (F), bromine (Br), and iodine (I) can be adopted.

The method for manufacturing a semiconductor device may further include the step of oxidizing and removing the carbon layer after the step of activating the impurity. Thereby, the carbon layer can be easily removed. It should be noted that, if it is necessary to perform sacrificial oxidation or gate oxidation on the silicon carbide layer after removal of the carbon layer, these treatments may be performed concurrently with the removal of the carbon layer by oxidation described above. More specifically, for example, the carbon layer may be removed by performing heat treatment of heating the silicon carbide layer in an atmosphere containing oxygen, and surface oxidation treatment such as sacrificial oxidation or gate oxidation may be performed on the silicon carbide layer by continuously holding the silicon carbide layer in the atmosphere containing oxygen.

In the method for manufacturing a semiconductor device, in the step of activating the impurity, the silicon carbide layer may be heated to a temperature range of not less than 1600°C and not more than 1900°C. Thereby, the introduced impurity can be sufficiently activated. In addition, even if heat treatment is performed at such a high temperature, the carbon film formed in the method for manufacturing a semiconductor device in accordance with the present invention can sufficiently protect the surface layer portion of the silicon carbide layer.

### ADVANTAGEOUS EFFECTS OF INVENTION

As is clear from the above description, the method for manufacturing a semiconductor device in accordance with the present invention can perform activation annealing while protecting a surface more reliably.

### BRIEF DESCRIPTION OF DRAWINGS

Fig. 1 is a schematic cross sectional view showing a structure of a MOSFET.
Fig. 2 is a flowchart schematically showing a method for manufacturing the MOSFET.
Fig. 3 is a schematic cross sectional view for illustrating the method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a schematic cross sectional view for illustrating the method for manufacturing the MOSFET.
Fig. 8 is a schematic cross sectional view for illustrating the method for manufacturing the MOSFET.
Fig. 9 is a schematic cross sectional view for illustrating the method for manufacturing the MOSFET.
Fig. 10 is a schematic cross sectional view for illustrating the method for manufacturing the MOSFET.

### DESCRIPTION OF EMBODIMENTS

Hereinafter, an embodiment of the present invention will be described with reference to the drawings. It should be noted that in the below-mentioned drawings, the same or corresponding portions are given the same reference characters and are not described repeatedly. Further, in the present specification, an individual orientation is represented by [], a group orientation is represented by <>, an individual plane is represented by (), and a group plane is represented by {}. In addition, a negative index is supposed to be crystallographically indicated by putting "-" (bar) above a numeral, but is indicated by putting the negative sign before the numeral in the present specification.

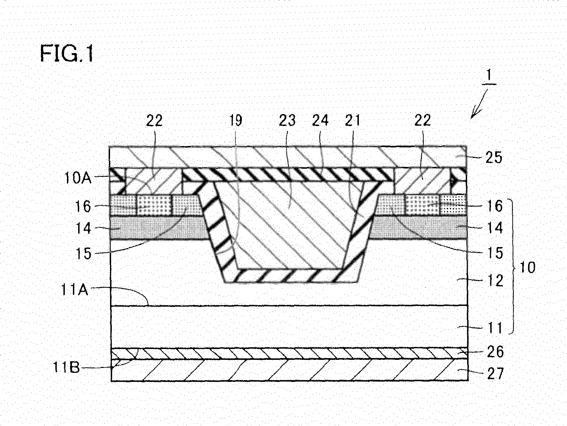

Firstly, as one embodiment of the present invention, a trench-type MOSFET (Metal Oxide Semiconductor Field Effect Transistor) as a semiconductor device, and a method for manufacturing the same will be described. Referring to Fig. 1, a MOSFET 1 includes a silicon carbide substrate 11 having n type conductivity (a first conductivity type), a drift layer 12 made of silicon carbide and having n type conductivity, a p type body region 14 having p type conductivity (a second conductivity type), an n⁺ region 15 having n type conductivity, and a p⁺ region 16 having p type conductivity. Silicon carbide substrate 11, drift layer 12, p type body region 14, n⁺ region 15, and p⁺ region 16 constitute a silicon carbide layer 10.

Drift layer 12 is formed on one main surface 11A of silicon carbide substrate 11, and has n type conductivity because it contains an n type impurity. The n type impurity contained in drift layer 12 is, for example, N (nitrogen), and is contained at a concentration (density) lower than that of an n type impurity contained in silicon carbide substrate 11. Drift layer 12 is an epitaxial growth layer formed on one main surface 11A of silicon carbide substrate 11. Drift layer 12 may include a buffer layer having an increased impurity concentration in the vicinity of an interface with silicon carbide substrate 11.

In silicon carbide layer 10, a trench 19 is formed which has a tapered shape with a width gradually narrowed from a main surface 10A on a side opposite to a silicon carbide substrate 11 side toward the silicon carbide substrate 11 side, and has a flat bottom portion extending along main surface 11A. Trench 19 may have a side wall formed to have an angle of not less than 45° and not more than 90° relative to a {0001} plane of silicon carbide constituting silicon carbide layer 10.

P type body region 14 is formed to include the side wall of trench 19 (i.e., constitute a portion of the side wall of trench 19) within silicon carbide layer 10, and to extend along main surface 11A in a direction away from the side wall of trench 19. P type body region 14 has p type conductivity because it contains a p type impurity. The p type impurity contained in p type body region 14 is, for example, Al (aluminum), B (boron), or the like.

N⁺ region 15 is formed to include the side wall of trench 19 within silicon carbide layer 10, and to fill a gap between p type body region 14 and main surface 10A (i.e., to extend from p type body region 14 to main surface 10A). Specifically, n⁺ region 15 is formed to be in contact with p type body region 14, and to include the side wall of trench 19 and main surface 10A. N⁺ region 15 contains an n type impurity, for example, P (phosphorus) or the like, at a concentration (density) higher than that of the n type impurity contained in drift layer 12.

P⁺ region 16 is formed within silicon carbide layer 10 to include main surface 10A and to be adjacent to (i.e., in contact with) n⁺ region 15. P⁺ region 16 contains a p type impurity, for example, Al or the like, at a concentration (density) higher than that of the p type impurity contained in p type body region 14. Trench 19 is formed to penetrate n⁺ region 15 and p type body region 14 and reach drift layer 12.

Further, referring to Fig. 1, MOSFET 1 includes a gate oxide film 21 serving as a gate insulating film, a gate electrode 23, a source contact electrode 22, an interlayer insulating film 24, a source wire 25, a drain electrode 26, and a backside surface protecting electrode 27.

Gate oxide film 21 is formed to cover a surface of trench 19 and to extend onto main surface 10A, and is made of, for example, silicon dioxide (SiO₂).

Gate electrode 23 is arranged in contact with gate oxide film 21 to fill trench 19. Gate electrode 23 is made of, for example, a conductor such as polysilicon, Al, or the like doped with an impurity.

Source contact electrode 22 is arranged in contact with n⁺ region 15 and p⁺ region 16 by extending from above n⁺ region 15 to above p⁺ region 16. Further, source contact electrode 22 is made of a material that can make ohmic contact with n⁺ region 15 and p⁺ region 16, for example, NiₓSi_{y} (nickel silicide), TiₓSi_{y} (titanium silicide), AlₓSi_{y} (aluminum silicide), TiₓAl_{y}Si_{z} (titanium aluminum silicide), or the like.

Interlayer insulating film 24 is formed above main surface 10A of silicon carbide layer 10 to surround gate electrode 23 together with gate oxide film 21 and to separate gate electrode 23 from source contact electrode 22 and source wire 25, and is made of, for example, silicon dioxide (SiO₂) serving as an insulator.

Source wire 25 is formed above main surface 10A of silicon carbide layer 10 to cover surfaces of interlayer insulating film 24 and source contact electrode 22. Further, source wire 25 is made of a conductor such as Al, and is electrically connected with n⁺ region 15 via source contact electrode 22.

Drain electrode 26 is formed in contact with a main surface 11 B of silicon carbide substrate 11 on a side opposite to a side on which drift layer 12 is formed. Drain electrode 26 is made of a material that can make ohmic contact with silicon carbide substrate 11, for example, the same material as that for source contact electrode 22, and is electrically connected with silicon carbide substrate 11.

Backside surface protecting electrode 27 is formed to cover drain electrode 26, and is made of, for example, Al or the like serving as a conductor.

Next, an operation of MOSFET 1 will be described. Referring to Fig. 1, in a state where gate electrode 23 has a voltage less than a threshold voltage, that is, in an OFF state, even if a voltage is applied between drain electrode 26 and source contact electrode 22, pn junction between p type body region 14 and drift layer 12 is reverse-biased, and thus a non-conductive state is obtained. On the other hand, when a voltage equal to or higher than the threshold voltage is applied to gate electrode 23, an inversion layer is formed in a channel region in the vicinity of a portion of p type body region 14 in contact with gate oxide film 21. As a result, n⁺ region 15 and drift layer 12 are electrically connected to each other, and a current flows between source contact electrode 22 and drain electrode 26.

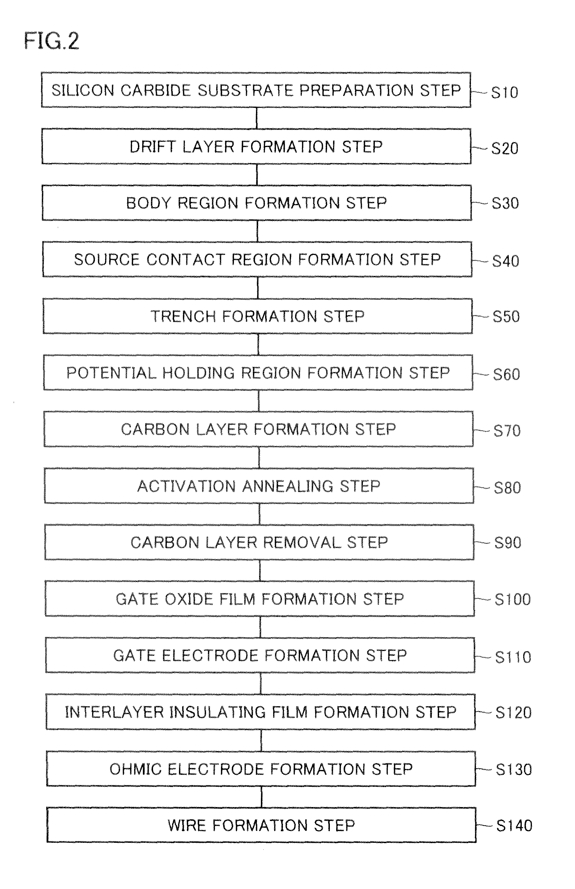

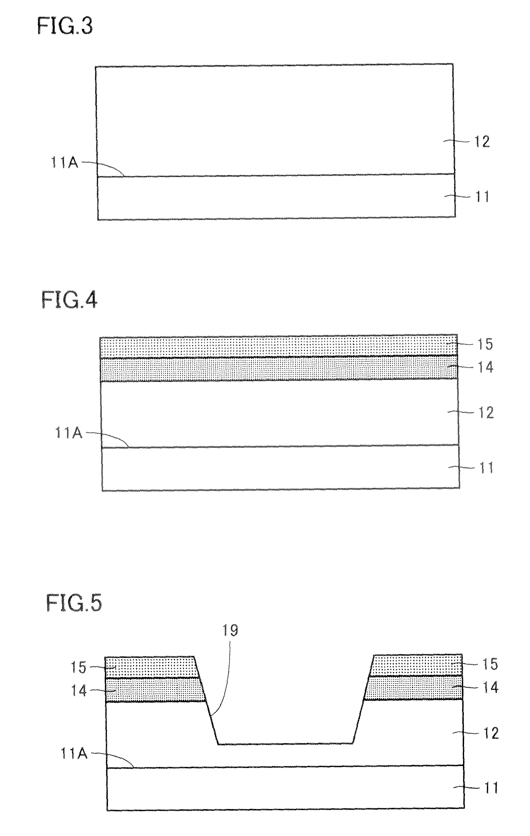

Next, one example of a method for manufacturing MOSFET 1 in the present embodiment will be described with reference to Figs. 2 to 10. Referring to Fig. 2, in the method for manufacturing MOSFET 1 in the present embodiment, firstly, a silicon carbide substrate preparation step is performed as a step (S10). In this step (S10), referring to Fig. 3, silicon carbide substrate 11 made of, for example, 4H hexagonal silicon carbide is prepared.

Next, a drift layer formation step is performed as a step (S20). In this step (S20), referring to Fig. 3, drift layer 12 made of silicon carbide is formed on one main surface 11A of silicon carbide substrate 11 by epitaxial growth.

Next, a body region formation step is performed as a step (S30). In this step (S30), referring to Figs. 3 and 4, p type body region 14 is formed by implanting, for example, Al ions into drift layer 12. On this occasion, p type body region 14 is formed to have a thickness equal to the combined thickness of p type body region 14 and n⁺ region 15 in Fig. 4.

Next, a source contact region formation step is performed as a step (S40). In this step (S40), referring to Fig. 4, n⁺ region 15 is formed by implanting, for example, P ions into p type body region 14 formed in step (S30). As a result, a structure shown in Fig. 4 is obtained.

Next, a trench formation step is performed as a step (S50). In this step (S50), trench 19 is formed by a method including dry etching such as RIE, thermal etching using a halogen-based gas, or a combination thereof, for example using a mask made of silicon dioxide having an opening at a desired region. Specifically, referring to Figs. 4 and 5, a mask having an opening is formed over n⁺ region 15, and thereafter trench 19 is formed which penetrates n⁺ region 15 and p type body region 14 and extends in a direction along main surface 11 A of silicon carbide substrate 11 (in Fig. 5, in a depth direction of the paper plane). On this occasion, trench 19 may be formed such that surfaces of p type body region 14 and n⁺ region 15 exposed from the side wall of the trench have an off angle of not less than 45° and not more than 90° relative to the {0001} plane.

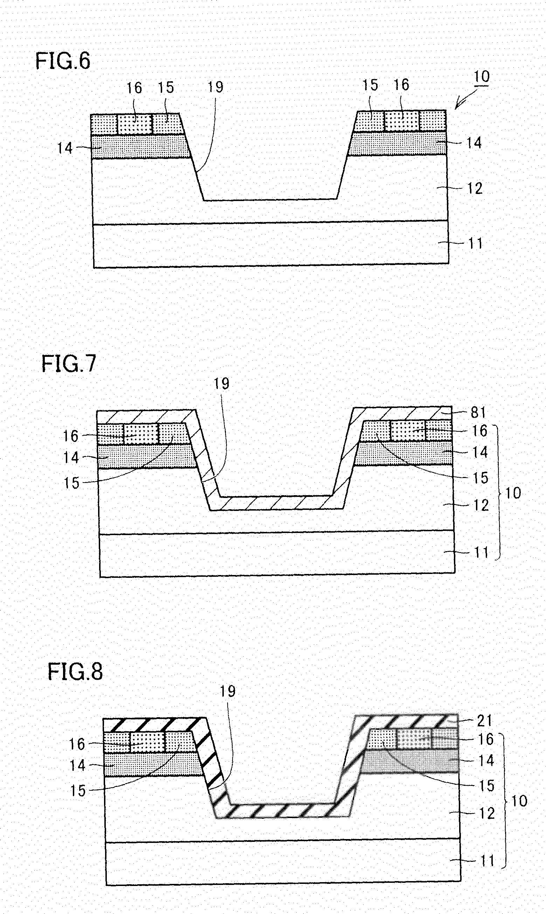

Next, a potential holding region formation step is performed as a step (S60). In this step (S60), referring to Figs. 5 and 6, p⁺ region 16 is formed by implanting, for example, Al ions into n⁺ region 15 formed in step (S50). The ion implantation for forming p⁺ region 16 can be performed, for example, by forming a mask layer made of silicon dioxide (SiO₂) and having an opening at a desired region into which ions are to be implanted, over a surface of n⁺ region 15. Thereby, silicon carbide layer 10 constituting MOSFET 1 is completed.

Next, a carbon layer formation step is performed as a step (S70). In this step (S70), a carbon layer is formed in a surface layer portion of silicon carbide layer 10 by selectively removing silicon from the surface layer portion. Specifically, referring to Figs. 6 and 7, silicon can be selectively removed, for example, by reaction of a halogen element and silicon constituting silicon carbide layer 10. Selective removal of silicon by reaction with a halogen element may be accomplished, for example, by treatment of heating the silicon carbide layer in an atmosphere including a gas containing the halogen element, or by treatment of holding the silicon carbide layer in a plasma containing the halogen element. Thereby, the silicon is selectively removed from a surface layer including the bottom wall and the side wall of trench 19 and upper surfaces of n⁺ region 15 and p⁺ region 16, and the surface layer is transformed into a carbon layer 81. Thus, carbon layer 81 serving as an anneal cap is formed.

Here, carbon layer 81 can have a thickness of, for example, not less than about 0.01 µm and not more than about 1.0 µm. Further, in a case where carbon layer 81 is formed by the treatment of heating the silicon carbide layer in an atmosphere including a gas containing a halogen element, carbon layer 81 can be formed, for example, by heating the silicon carbide layer to a temperature range of not less than 800°C and not more than 1200°C, in an atmosphere containing chlorine gas and fluorine gas, for a time period of not less than one minute and less than 60 minutes. Further, in a case where carbon layer 81 is formed by the treatment of holding the silicon carbide layer in a plasma containing a halogen element, carbon layer 81 can be formed by appropriately setting plasma power and pressure conditions for a reaction gas. Preferably, formed carbon layer 81 has a graphene structure, a diamond structure, or a DLC (Diamond Like Carbon) structure.

Next, an activation annealing step is performed as a step (S80). In this step (S80), the impurities introduced in steps (S30), (S40), and (S60) are activated by heating silicon carbide layer 10. Specifically, silicon carbide layer 10 having carbon layer 81 formed as shown in Fig. 7 is heated to a temperature range of not less than 1600°C and not more than 1900°C, and held for a time period of not less than one minute and not more than 30 minutes. Thereby, desired carriers are generated in the regions having the impurities introduced therein.

Next, a carbon layer removal step is performed as a step (S90). In this step (S90), for example, carbon layer 81 formed in step (S70) is oxidized and thereby removed. Specifically, carbon layer 81 is removed, for example, by performing heat treatment of heating the silicon carbide layer in an atmosphere containing oxygen. The removal of carbon layer 81 by oxidation treatment can be performed concurrently or consecutively with sacrificial oxidation treatment on silicon carbide layer 10 or formation of the gate oxide film described below.

Next, a gate oxide film formation step is performed as a step (S100). In this step (S100), referring to Fig. 8, gate oxide film 21 is formed, for example, by performing heat treatment of heating the silicon carbide layer to 1300°C in an oxygen atmosphere and holding it for 60 minutes.

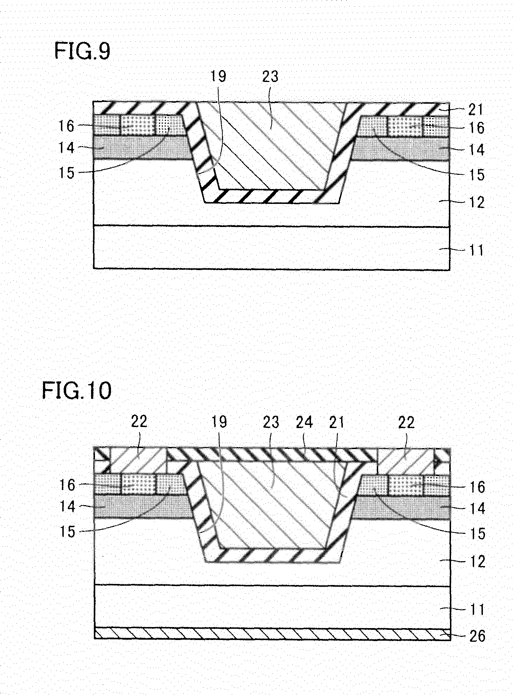

Next, a gate electrode formation step is performed as a step (S110). In this step (S110), referring to Fig. 9, a polysilicon film filling trench 19 is formed, for example, by a LPCVD (Low Pressure Chemical Vapor Deposition) method. Thereby, gate electrode 23 is formed.

Next, an interlayer insulating film formation step is performed as a step (S 120). In this step (S 120), referring to Figs. 9 and 10, interlayer insulating film 24 made of SiO₂ serving as an insulator is formed, for example, by a P (Plasma)-CVD method, to cover gate electrode 23 and gate oxide film 21.

Next, an ohmic electrode formation step is performed as a step (S 130). In this step (S 130), referring to Fig. 10, a hole portion penetrating interlayer insulating film 24 and gate oxide film 21 is formed at a desired region in which source contact electrode 22 is to be formed. Then, for example, a film made of Ni is formed to fill the hole portion. On the other hand, a film to serve as drain electrode 26, for example, a film made of Ni, is formed to be in contact with the main surface of silicon carbide substrate 11 on the side opposite to the drift layer 12 side. Thereafter, alloy heating treatment is performed to silicidize at least a portion of the films made of Ni, and thereby source contact electrode 22 and drain electrode 26 are completed.

Next, a wire formation step is performed as a step (S140). In this step (S140), referring to Figs. 10 and 1, for example, source wire 25 made of Al serving as a conductor is formed above main surface 10A by an evaporation method to cover upper surfaces of interlayer insulating film 24 and source contact electrode 22. Further, backside surface protecting electrode 27 also made of Al is formed to cover drain electrode 26. Through the above procedure, the method for manufacturing MOSFET 1 as a semiconductor device in the present embodiment is completed.

In the method for manufacturing MOSFET 1 in the above embodiment, carbon layer 81 serving as a protective film (anneal cap) is formed by selectively removing silicon from the surface layer portion of silicon carbide layer 10 in step (S70). Since carbon layer 81 is formed by transforming the surface layer portion, instead of being formed by depositing a new layer on silicon carbide layer 10, a crack and the like due to a difference in linear expansion coefficient between the protective film and the silicon carbide layer and the like are less likely to occur. Further, since carbon layer 81 is formed through such a process, it is also relatively easy to form carbon layer 81 to cover a surface having a trench formed therein and thus having a complicated shape as in the above embodiment. As a result, the method for manufacturing MOSFET 1 in the present embodiment can perform activation annealing in step (S80) while protecting the surface more reliably.

Although the above embodiment has described the method for manufacturing a trench-type MOSFET, the method for manufacturing a semiconductor device in accordance with the present invention is not limited thereto, and is also applicable, for example, to a method for manufacturing a planar-type MOSFET. Further, the method for manufacturing a semiconductor device in accordance with the present invention is widely applicable to a method for manufacturing a semiconductor device, such as not only a MOSFET but also a JFET (Junction Field Effect Transistor), an IGBT (Insulated Gate Bipolar Transistor), a diode, and the like, which includes a process for performing activation annealing on an impurity introduced into a silicon carbide layer.

It should be understood that the embodiment disclosed herein is illustrative and non-restrictive in every respect. The scope of the present invention is defined by the scope of the claims, rather than the description above, and is intended to include any modifications within the scope and meaning equivalent to the scope of the claims.

### INDUSTRIAL APPLICABILITY

The method for manufacturing a semiconductor device in accordance with the present invention is particularly advantageously applicable to manufacturing of a semiconductor device required to perform activation annealing while sufficiently protecting a surface of a silicon carbide layer.

### REFERENCE SIGNS LIST

1: MOSFET, 10: silicon carbide layer, 10A: main surface, 11: silicon carbide substrate, 11A, 11B: main surface, 12: drift layer, 14: p type body region, 15: n⁺ region, 16: p⁺ region, 19: trench, 21: gate oxide film, 22: source contact electrode, 23 gate electrode, 24: interlayer insulating film, 25: source wire, 26: drain electrode, 27: backside surface protecting electrode, 81: carbon layer.

## Claims

1. A method for manufacturing a semiconductor device (1), comprising the steps of:
introducing an impurity into a silicon carbide layer (10);
forming a carbon layer (81) in a surface layer portion of said silicon carbide layer (10) having said impurity introduced therein, by selectively removing silicon from said surface layer portion; and
activating said impurity by heating said silicon carbide layer (10) having said carbon layer (81) formed therein.

2. The method for manufacturing a semiconductor device (1) according to claim 1, wherein, in the step of forming said carbon layer (81), the silicon is selectively removed by reaction of a halogen element and the silicon.

3. The method for manufacturing a semiconductor device (1) according to claim 2, wherein, in the step of forming said carbon layer (81), the silicon is selectively removed by heating said silicon carbide layer (10) in an atmosphere including a gas containing the halogen element.

4. The method for manufacturing a semiconductor device (1) according to claim 2, wherein, in the step of forming said carbon layer (81), the silicon is selectively removed by holding said silicon carbide layer (10) in a plasma containing the halogen element.

5. The method for manufacturing a semiconductor device (1) according to any of claims 1 to 4, further comprising the step of oxidizing and removing said carbon layer (81) after the step of activating said impurity.

6. The method for manufacturing a semiconductor device (1) according to any of claims 1 to 5, wherein, in the step of activating said impurity, said silicon carbide layer (10) is heated to a temperature range of not less than 1600°C and not more than 1900°C.
